# EUROPEAN PATENT APPLICATION

(11) **EP 4 672 324 A1**
(43) Date of publication of application: **31.12.2025**
(21) Application number: 25174145.0
(22) Date of filing: 05.05.2025
(51) Int. Cl.: H01L 23/367, H01L 23/373, H01L 21/48, H01L 23/498, H01L 23/538, H01L 25/065, H01L 25/07, H01L 25/075, H01L 23/40

(54) **MICRO-STRUCTURE ARRAY FOR MITIGATION OF HOT SPOTS IN INTEGRATED CIRCUIT PACKAGES**

(30) Priority: 27.06.2024 US 202418757197
(71) Applicant: INTEL Corporation, Santa Clara, CA 95054 (US)
(72) Inventor: Meng, Yuan, Chandler, 85226 (US); Zandavi, Seyed, Phoenix, 85048 (US); Uppal, Aastha, Chandler, 85226 (US); Deb, Nabankur, Beaverton, 97003 (US); Li, Xiaoqian, Chandler, 85248 (US); Chang, Je-Young, Tempe, 85283 (US); Widodo, Trianggono, Hillsboro, 97124 (US); Brun, Xavier, Chandler, 85224 (US)
(74) Representative: Goddar, Heinz J.

(57) **Abstract**

An apparatus comprises a first integrated circuit (IC) die comprising a first surface and a second IC die laterally adjacent to the first IC die comprising a second surface. A structural member over an entirety of the first and second IC dies includes a first side facing the first and second surfaces, a second side opposite the first side, and one or more passive features. The apparatus also comprises a layer of dielectric material contacting the first side and both of the first and second surfaces. The layer may comprise a plurality of first metal features extending between the first side and the first surface, where at least one of the metal features contacts one of the passive features. The structural member may comprise a plurality of second metal features extending between the first and second sides. The passive features may comprise silicon or the second metal features.

## Description

### BACKGROUND

In electronics manufacturing, integrated circuit (IC) packaging is a stage of semiconductor device fabrication in which an IC that has been monolithically fabricated on a chip (or die) is assembled into a "package" that can protect the IC chip from physical damage. The package can also communicatively connect the IC chip to other packaged IC chips and/or a scaled host component, such as a package substrate, or a printed circuit board. Multiple IC chips can be co-assembled, for example, into a multi-die package (MCP).

In traditional methods, IC chips are placed side by side on a substrate. To obtain tighter integration than is possible using traditional methods, IC chips may be stacked on top of each other using three-dimensional (3D) packaging techniques. 3D packaging generally requires higher interconnect density, which may be achieved using a hybrid bonding interconnect (HBI) process. One challenge with 3D IC packaging is providing effective cooling for the dies within the package.

### BRIEF DESCRIPTION OF THE DRAWINGS

The subject matter described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Views referred to as "cross-sectional", "profile" and "plan" correspond to orthogonal planes within a cartesian coordinate system. Thus, cross-sectional and profile views are taken in the x-z plane, and plan views are taken in the x-y plane. Typically, profile views in the x-z plane are cross-sectional views. Where appropriate, drawings are labeled with axes to indicate the orientation of the figure. Further, where considered appropriate, reference labels have been repeated among the figures to indicate corresponding or analogous elements. In the figures:
FIG. 1 illustrates an example integrated circuit (IC) package in accordance with some embodiments;
FIGS. 2A-2B illustrate exemplary methods for fabricating alternative examples of IC packages, according to some embodiments;
FIGS. 3A-3I illustrate a series of cross-sectional views of stages of fabrication of a first example IC package with an array of heat conducting features in a structural silicon member, according to some embodiments;
FIGS. 4A-4D, together with FIGS. 3A-3E, illustrate a series of cross-sectional views of stages of fabrication of a second example IC package with an array of heat conducting features in a hybrid bonding interface layer, according to some embodiments;
FIGS. 5A-5D illustrate a series of cross-sectional views of stages of fabrication of a third example IC package that includes arrays of heat conducting features in both structural silicon and the hybrid bonding interface layer, according to some embodiments;
FIGS. 6A-6D illustrate a series of cross-sectional views of stages of fabrication of a fourth example IC package that includes arrays of heat conducting features in structural silicon, a hybrid bonding interface layer, and a top IC die, according to some embodiments;
FIG. 7A illustrates an example IC package in accordance with some embodiments, and FIG. 7B illustrates a cross-section side view of the IC package of FIG. 7A;
FIG. 8 illustrates a mobile computing platform and a data server machine employing one or more apparatus comprising an IC package comprising an array of heat conducting features in a structural silicon member, a hybrid bonding interface layer, and/or a top IC die, in accordance with some embodiments; and
FIG. 9 is a functional block diagram of an electronic computing device, in accordance with some embodiments.

### DETAILED DESCRIPTION

Embodiments are described with reference to the enclosed figures. While specific configurations and arrangements are depicted and discussed in detail, this is done for illustrative purposes only. Persons skilled in the relevant art will recognize that other configurations and arrangements are possible without departing from the spirit and scope of the description. It will be apparent to those skilled in the relevant art that techniques and/or arrangements described herein may be employed in a variety of other systems and applications other than what is described in detail herein.

Reference is made in the following detailed description to the accompanying drawings, which form a part hereof and illustrate exemplary embodiments. Further, it is to be understood that other embodiments may be utilized and structural and/or logical changes may be made without departing from the scope of claimed subject matter. It should also be noted that directions and references, for example, up, down, top, bottom, and so on, may be used merely to facilitate the description of features in the drawings. Therefore, the following detailed description is not to be taken in a limiting sense and the scope of claimed subject matter is defined solely by the appended claims and their equivalents.

In the following description, numerous details are set forth. However, it will be apparent to one skilled in the art, that embodiments may be practiced without these specific details. In some instances, well-known methods and devices are shown in block diagram form, rather than in detail, to avoid obscuring the embodiments. Reference throughout this specification to "an embodiment" or "one embodiment" or "some embodiments" means that a particular feature, structure, function, or characteristic described in connection with the embodiment is included in at least one embodiment. Thus, the appearances of the phrase "in an embodiment" or "in one embodiment" or "some embodiments" in various places throughout this specification are not necessarily referring to the same embodiment. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses all possible combinations of one or more of the associated listed items.

The terms "coupled" and "connected," along with their derivatives, may be used herein to describe functional or structural relationships between components. These terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause-and-effect relationship).

The terms "over," "under," "between," and "on" as used herein refer to a relative position of one component or material with respect to other components or materials where such physical relationships are noteworthy. For example, in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer is in direct physical contact with that second material/layer. Similar distinctions are to be made in the context of component assemblies.

The vertical orientation is in the z-direction and it is understood that the terms of "top", "bottom", "above," and "below" used herein refer to relative positions in the z-dimension with the usual meaning. However, embodiments are not necessarily limited to the example orientations or configurations illustrated in the figures.

As used throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C.

Unless otherwise specified in the specific context of use, the term "predominantly" means more than 50%, or more than half. For example, a composition that is predominantly a first constituent means more than half of the composition is the first constituent (e.g., <50 at. %). The term "primarily" means the most, or greatest, part. For example, a composition that is primarily a first constituent means the composition has more of the first constituent than any other constituent. A composition that is primarily first and second constituents means the composition has more of the first and second constituents than any other constituent. The term "substantially" means there is only incidental variation. For example, composition that is substantially a first constituent means the composition may further include less than 1% of any other constituent. A composition that is substantially first and second constituents means the composition may further include less than1% of any constituent substituted for either the first or second constituent.

The term "die" generally refers to a piece of semiconductor wafer that has been cut into rectangular sections referred to as dies. Each die has integrated circuitry on one or both sides. The terms "substrate" or "package substrate" are used to refer to the substrate of an IC package. Die or dies contained within an IC package may be coupled to a package substrate. The substrate may include a dielectric having conductive structures on or embedded with the dielectric.

The term "IC package" generally refers to a self-contained carrier of one or more IC dies, where the dice are attached to the package substrate, and may be encapsulated for protection, with integrated or wire-bonded interconnects between the dice and leads, pins or bumps located on the external portions of the package substrate. The package may contain a single die, or multiple dice, providing a specific function. The package is usually mounted on a printed circuit board for interconnection with other packaged integrated circuits and discrete components, forming a larger circuit.

For purposes of this disclosure, dielectric material may be incorporated into an integrated circuit package as layers of laminate film or as a resin molded over integrated circuit dice mounted on the substrate. The term "metallization" generally refers to metal layers formed over and through dielectric material in an IC die or package substrate. The metal layers are generally patterned to form metal structures such as traces and bond pads. The metallization of an IC die or package substrate may be confined to a single layer or in multiple layers separated by layers of dielectric.

The examples described herein are directed to micro-structure arrays for mitigation of hot spots in IC packages. In particular, the examples are directed to arrays of micro-sized structures of heat conducting material, e.g., copper, for mitigation of hot spots in top dies in IC packages.

The IC dies stacked on top of each other in 3D IC packages include electrical circuitry to perform a variety of functions. The IC dies, which may be referred to as "active" IC dies, may include active circuitry, i.e., circuitry to store and/or process data, or provide electronic or device functionality when in operation. Example active IC dies include memory, logic, communication, processor, and photonic dies. In other examples, active IC dies may include power supply control circuits and/or all or part of voltage regulation circuitry. Active circuitry comprises active features; as used herein, the term "active features" means transistors, resistors, capacitors, inductors, metal traces and vias for the conduction of electrical signals, and similar structures. Removing the heat generated by active IC dies, i.e., cooling IC package components, is a challenge faced in 3D IC packages.

During the manufacturing of 3D IC packages, multiple instances of IC dies may be present on the surface of a base wafer. To facilitate handling and add mechanical strength, a **structural member** is attached to the IC dies on the base wafer. The structural member may be referred to herein as a structural silicon wafer, structural silicon member, structural silicon handle, or structural silicon. In some examples, the structural member is bulk silicon that has not been processed to include active features. In some examples, the structural member is a monolithic body of substantially pure silicon. In embodiments, structural silicon may be substantially monocrystalline silicon (i.e., substantially pure silicon) with only a minority concentration of one or more impurities. In some examples, structural silicon is 99% pure with 1% or less impurities. In some examples, structural silicon is 98% pure with 2% or less impurities. In some examples, structural silicon is 95% pure with 2% or less impurities.

In various embodiments, a structural member comprises one or more "passive" features. As used herein, the term "passive feature" means a feature that is not an active feature. A passive feature may provide mechanical strength or a heat conducting function, e.g., a cooling function. A structural member includes a first side and a second side opposite the first side. In some examples, a structural member comprises bulk silicon and bulk silicon at a first or second side of the structural member is a passive feature. In some examples, one or more vias comprising a thermally conductive material, e.g., metal features, extending between the first and second sides are passive features. In some examples, a structural member is devoid of circuitry to store or perform operations on data.

In some examples, the structural member is attached to the top surfaces of the top IC dies using a hybrid bonding process. A thin layer of dielectric material, e.g., oxide, is formed on both the top surfaces IC dies and a surface of the structural silicon. In hybrid bonding, the dielectric layers are bonded together with Van der Waals force. (If the outer layers of two surfaces to be attached by hybrid bonding include metal portions, high temperature processing also causes metal-to-metal bonds (metallurgically interdiffused metal) to be formed.) While structural silicon provides mechanical support and facilitates handling, structural silicon and the dielectric bonding interface add thermal resistance, which inhibits cooling of 3D stacked die packages. An advantage of the examples described herein is that heat may be conducted away from local "hot spots" in top dies thereby cooling 3D stacked die packages.

The layers of dielectric on the surfaces of IC dies and the structural silicon are typically approximately 1-2 microns thick. As a result, the hybrid bonding interface may have a thermal conductivity of approximately 1 W/m·K. The thermal conductivity of the structural silicon member is approximately 130 W/m·K. In examples, micro-sized arrays of features, e.g., pillars, comprised of a material with good thermal conductivity are provided in local regions corresponding with "hot spots" in the top die in a stack of two or more dies. In some examples, the micro-sized arrays of features described herein may be provided in any suitable region within an IC package.

In the examples disclosed herein, the heat-conducting features comprise materials with high thermal conductivity (high-k, where k is the coefficient of heat conductivity) materials, such as, but not limited to, copper, gold, silver, nickel, or aluminum. In some examples, micro-arrays of features are integrated into a structural silicon member or handle. In other examples, the micro-arrays of features are integrated into the dielectric bonding interface between the structural silicon member and the IC dies. In still other examples, the micro-arrays of features are integrated into both the structural silicon handle and the dielectric bonding interface. In further examples, micro-arrays of features may be integrated into one or more of the top IC dies in an IC package in some embodiments. In the examples disclosed herein, the micro-arrays of features advantageously enhance cooling of 3D stacked die packages. A further advantage of the micro-arrays is that known manufacturing tools and techniques may be used to fabricate the features.

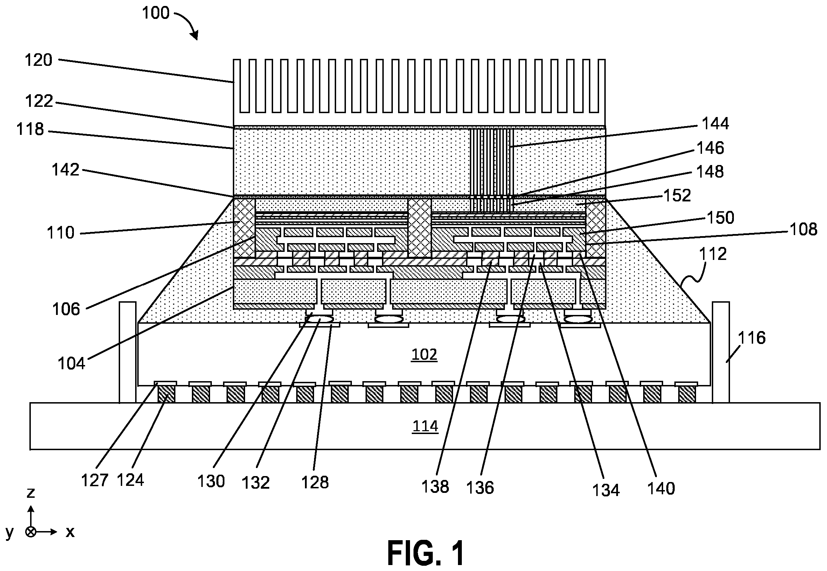

**FIG. 1** illustrates an example integrated circuit (IC) package in accordance with some embodiments. In this example, the IC package 100 includes a package substrate 102 and three IC dies. In other examples, the IC package 100 may have more or fewer dies. In the illustrated example, the IC package 100 includes IC die 104 is mounted on the package substrate 102, and IC dies 106 and 108 mounted (stacked) on IC die 104. It is not essential that an IC package include stacked IC dies. In some examples, IC dies in an IC package are not stacked on one another. The IC dies 104, 106, and 108 are active devices and may include circuitry to perform any desired function, e.g., logic, data processing, data communication, or memory. In some examples, any of IC dies 104, 106, and 108 may be a photonic IC or a processor.

A first dielectric material 110 is provided between IC dies 106 and 108 and over IC die 104. First dielectric material 110 may comprise materials comprising organic polymers that may or may not include inorganic fillers. In some examples, first dielectric material 110 may comprise an epoxy material. In other examples, first dielectric material 110 is any suitable dielectric material. In addition, the IC dies 104, 106, and 108 may be enclosed in a mold material 112. In some examples, mold material 112 is an organic mold material that may or may not include filler material. In other examples, mold material 112 is any suitable dielectric material.

Package substrate 102 is mounted within a socket 116 on a circuit board 114. A structural silicon member 118 is attached to the top surfaces of IC dies 106 and 108 and an upper surface of first dielectric material 110. In the example illustrated in FIG. 1, a heat sink 120 is attached to a top surface of structural silicon member 118 by a suitable thermal interface material 122, such as a thermal paste, or an epoxy. In other examples, a heat spreader, or a similar device may be attached to the top surface of the structural silicon member 118. In other examples, the IC package does not include heat sink 120, or a heat spreader or similar device.

In the example illustrated in FIG. 1, package substrate 102 has an array of contact pads or lands 127 on or at a bottom surface proximate the circuit board 114, and another array of contact pads or lands 128 on or at a top surface proximate IC die 104. The package substrate 102 is electrically coupled to the circuit board 114 by second level interconnects 124, e.g., solder features, that couple contact pads 127 with metal features (not shown) on circuit board 114. In the example of FIG. 1, IC die 104 has an array of contact pads or lands 130 on or at a bottom surface of the IC die. The IC die 104 is electrically and mechanically coupled to package substrate 102 by first level interconnects 132, e.g., solder features, that couple contact pads 128 with contact pads 130.

In the example illustrated in FIG. 1, IC die 104 has metal features 134, e.g., contacts or pads, at a top surface. In addition, IC dies 106 and 108 have metal features 136, e.g., contacts or pads, at respective bottom surfaces that are aligned with metal features 134. Metal features 134 may be flush with the surface and separated by a dielectric material 138. Similarly, metal features 136 may be flush with their respective surfaces and separated by a dielectric material 140.

In some examples, IC dies 106 and 108 are electrically and mechanically coupled to IC die 104 using a hybrid bonding technique. Surface metal features 136 embedded within dielectric 140 of IC dies 106 and 108 are directly fused to surface metal features 134 embedded within dielectric 138 of IC die 104. The hybrid bonded interface between the dies 104 and 106, and dies 104 and 108, may include both metallurgically interdiffused metals and chemically bonded insulators. In other examples, IC dies 106 and 108 may be electrically and mechanically coupled to IC die 104 using solder bonds or any other suitable technique.

As can be seen in the example illustrated in FIG. 1, there is a layer 142 of dielectric material between the top surfaces of IC dies 106, 108 and the structural silicon member 118. The layer 142 may be referred to as hybrid bonding interface layer 142. The hybrid bonding interface layer 142 is also between a top surface of first dielectric material 110 and structural silicon member 118. In some examples, hybrid bonding interface layer 142 comprises an oxide of silicon. IC dies 106 and 108 are attached to the structural silicon member 118 at the hybrid bonding interface layer 142 in a hybrid bonding technique. The hybrid bonding interface layer 142 comprises fused layers of dielectric material on the respective surfaces of IC dies 106, 108, the first dielectric material 110, and the structural silicon 118. In some examples, hybrid bonding interface layer 142 includes both metallurgically interdiffused metals and chemically bonded insulators. In some examples, the hybrid bonding interface layer 142 has a thickness in the range of approximately 1 - 4 microns.

In the example illustrated in FIG. 1, an array of features 144 comprised of a material or materials with high thermal conductivity are integrated into structural silicon member 118. In some examples, the features 144 are elongated structures, e.g., pillars, that extend vertically between a bottom surface of structural silicon member 118 proximate hybrid bonding interface layer 142 and a top surface proximate heat sink 120. The structural silicon may have a thickness in a range of about 30 µm to 1500 µm. Accordingly, features 144 may have a height (z-dimension) within the range of about 30 µm to 1500 µm. In some example, thickness (z-dimension) of the structural silicon is equal to or greater than the thickness of one or more of the IC dies 104, 106, and 108. The array of features 144 are passive in that they are not connected or coupled to any active devices, metallization, or electrical circuitry. In some examples, the features 144 have a diameter or a distance spanning a cross-sectional area in a plane perpendicular to their height (z-direction) in a range of approximately 3-10 microns. In some examples, the features 144 may be spaced apart from one another by a distance in a range of approximately 2-7 microns. The number of vertical features 144 in an array varies in different examples according the size of a hot spot in a top die 106, 108. In some examples, the number of vertical features 144 in an array is in a range of approximately 100-1000 features. In some examples, the cross-sectional area in a plane perpendicular to their height (z-direction) of an array of features 144 is in a range of approximately 0.5 x 1.0 mm to 2.5 x 3.5 mm.

Also illustrated in the example of FIG. 1, an array of features 146 comprised of a material or materials with high thermal conductivity are integrated into the hybrid bonding interface layer 142. In some examples, the features 146 are structures that extend vertically through the hybrid bonding interface layer 142 between a bottom surface of structural silicon member 118 and a top surface of a top IC die, e.g., IC die 106, 108. As mentioned, the hybrid bonding interface layer 142 has a thickness in the range of approximately 1-4 microns. Accordingly, features 146 may have a height (z-dimension) within the range of about 1-4 µm. The array of features 146 are passive in that they are not connected or coupled to any active devices, metallization, or electrical circuitry. In some examples, the features 146 have a diameter or a distance spanning a cross-sectional area in a plane perpendicular to their height (z-direction) in a range of approximately 3-10 microns. In some examples, the features 146 may be spaced apart from one another by a distance in a range of approximately 2-7 microns. The number of vertical features 146 in an array varies in different examples according the size of a hot spot in a top die 106, 108. In some examples, the number of vertical features 146 in an array is in a range of approximately 100-1000 features. In some examples, the cross-sectional area in a plane perpendicular to their height (z-direction) of an array of features 146 is in a range of approximately 0.5 x 1.0 mm to 2.5 x 3.5 mm. In the example illustrated in FIG. 1, each feature 146 is aligned with a feature 144 within the structural silicon. In other examples, one or more features 146 are offset from (not aligned with) features 144 within the structural silicon.

In the example of FIG. 1, top IC dies 106, 108 have multiple layers 150 comprising active devices, e.g., transistors, metallization, and dielectric material. At their front sides, the top IC dies 106, 108 have metal features 136 separated by a dielectric material 140. The top IC dies 106, 108 have back sides opposite their front sides of the dies that face the structural silicon member 118. A layer 152 of silicon is between the back sides and the multiple layers 150 (active device, metallization, and dielectric layers) in each of the IC dies 106, 108. The layer 152 of silicon may be bulk silicon and may have thickness of about 0.1-0.5 mm in some examples. In some examples, layer 152 is the same or similar material as the structural silicon 118.

As shown in the example of FIG. 1, an array of features 148 comprised of a material or materials with high thermal conductivity are included within a top IC die, e.g., IC die 106, 108. In some examples, the features 148 are structures that extend vertically through at least one layer of a top IC die, e.g., layer 152. The vertical extent of features 148 will vary depending on the architecture of the particular device. In an example, an array of features 148 are elongated structures, e.g., pillars, that extend vertically from the back side (top side in FIG. 1) of a top side IC die through layer 152 to a dielectric layer within the die. In some examples, features 148 have a height (z-direction) in a range of about 0.1-0.5 mm. The array of features 148 are passive in that they are not connected or coupled to any active devices, metallization, or electrical circuitry within a top die. In some examples, the features 148 have a diameter or a distance spanning a cross-sectional area in a plane perpendicular to their height (z-direction) in a range of approximately 3-10 microns. In some examples, the features 148 may be spaced apart from one another by a distance in a range of approximately 2-7 microns. The number of vertical features 148 in an array varies in different examples according the size of a hot spot in a top die 106, 108. In some examples, the number of vertical features 148 in an array is in a range of approximately 100 - 1000 features. In some examples, the cross-sectional area in a plane perpendicular to their height (z-direction) of an array of features 148 is in a range of approximately 0.5 x 1.0 mm to 2.5 x 3.5 mm. In the example illustrated in FIG. 1, each feature 148 is aligned with a feature 146 within the hybrid bonding interface layer 142. In other examples, one or more features 148 are offset from (not aligned with) features 146 within the hybrid bonding interface layer 142.

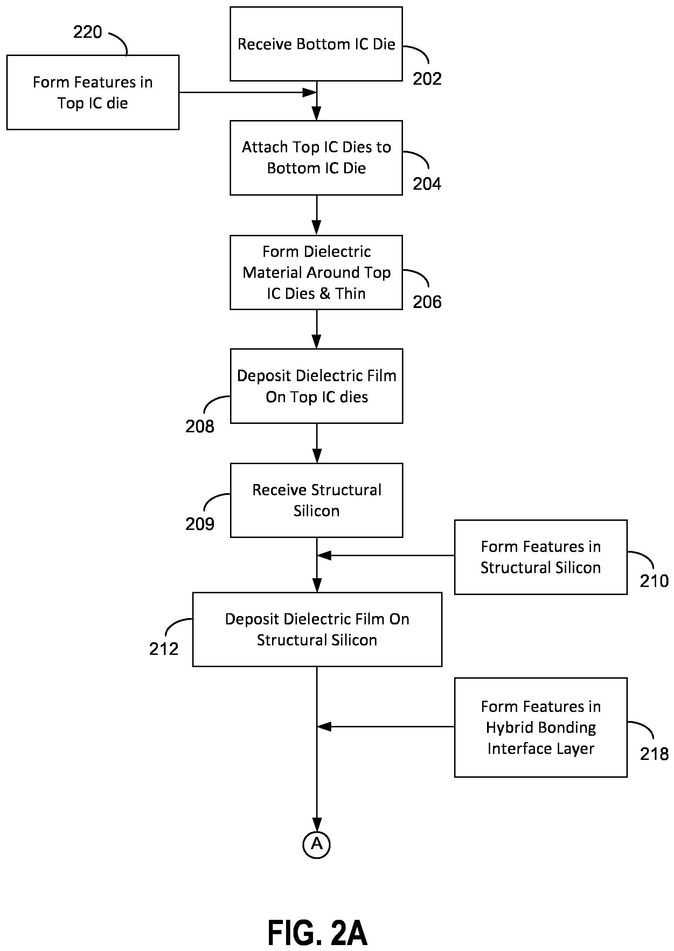

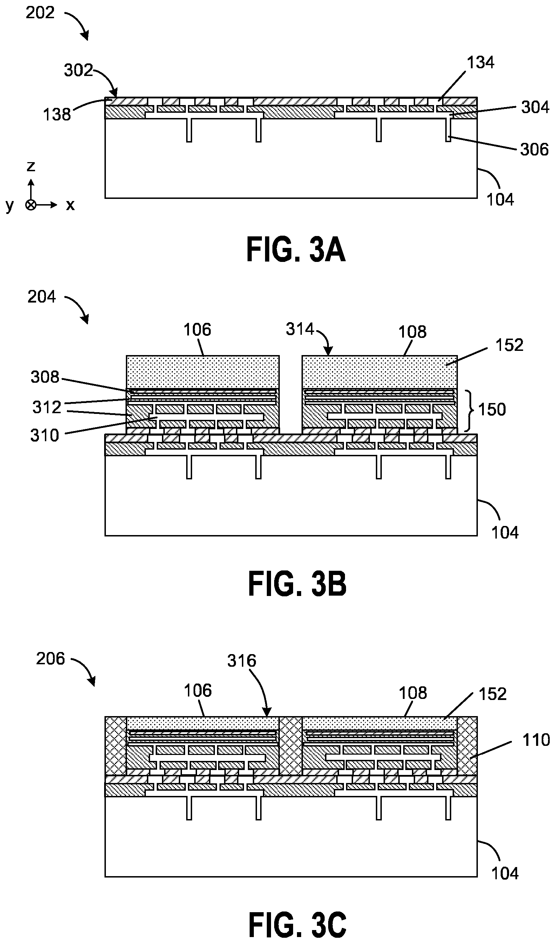

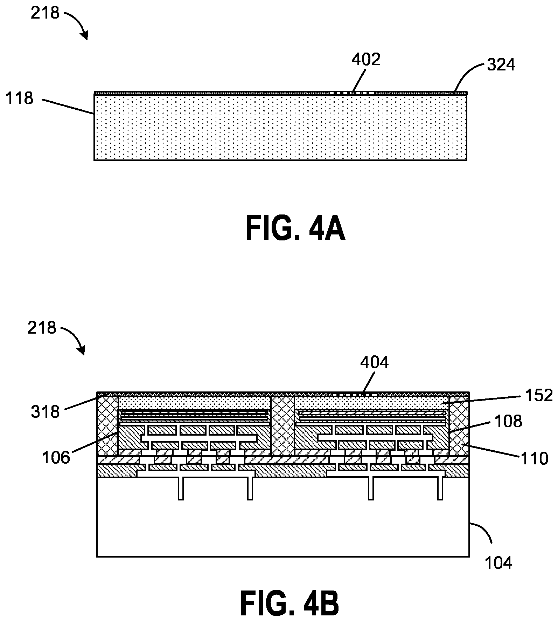

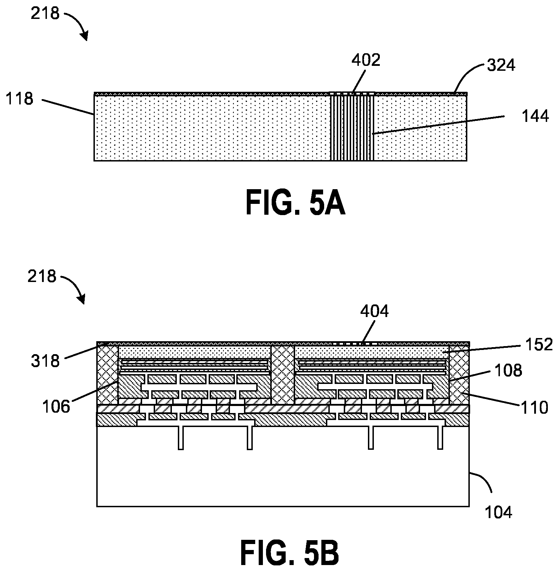

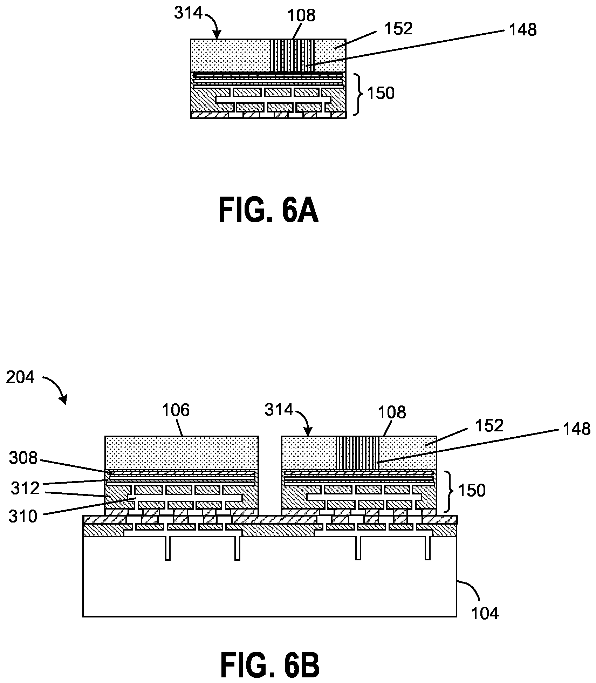

FIGS. 2A-2B illustrate exemplary methods for fabricating alternative examples of IC packages, according to some embodiments. FIGS. 3A-3I illustrate a series of cross-sectional views of stages of fabrication of a first example IC package 300 with an array of heat conducting features in a structural silicon member. FIGS. 4A-4D, together with FIGS. 3A-3E, illustrate a series of cross-sectional views of stages of fabrication of a second example IC package 400 with an array of heat conducting features in a hybrid bonding interface layer. FIGS. 5A-5D illustrate a series of cross-sectional views of stages of fabrication of a third example IC package 500 that includes heat conducting features in both structural silicon and the hybrid bonding interface layer. FIGS. 6A-6D illustrate a series of cross-sectional views of stages of fabrication of a fourth example IC package 600 that includes heat conducting features in structural silicon, a hybrid bonding interface layer, and a top IC die. While FIGS. 3A-3I, FIGS. 4A-4D, FIGS. 5A-5D, and FIGS. 6A-6D illustrate manufacturing states of an IC package, the manufacturing process is performed at the wafer level in some examples.

The example IC packages 300, 400, 500, and 600 shown respectively in FIGS. 3A-3I, FIGS. 4A-4D, FIGS. 5A-5D, and FIGS. 6A-3D are similar to the example IC package 100 illustrated in FIG. 1. Except as noted below, the description of example IC package 100 applies equally to first example IC package 300, second example IC package 400, third example IC package 500, and fourth example IC package 600. Accordingly, the same reference numbers used in the description of example IC package 100 are used to describe the same or similar features of first example IC package 300, second example IC package 400, third example IC package 500, and fourth example IC package 600.

Referring to **FIG. 2A****,** a bottom IC die, e.g., IC die 104, is received from an upstream operation at manufacturing stage 202. **FIG. 3A** illustrates a simplified cross-sectional view of IC die 104 at manufacturing stage 202. In the example illustrated in FIG. 3A, the IC die 104 includes metal features 134 separated by a dielectric material 138 at a top surface 302. IC die 104 also includes various metallization 304 and vias 306.

Top IC dies, e.g., IC dies 106, 108, are attached to the top surface 302 of bottom IC die 104 at manufacturing stage 204. **FIG. 3B** illustrates a simplified cross-sectional view of IC dies 104, 106, and 108 at manufacturing stage 204. The example in FIG. 3B shows IC dies 106, 108 after they have been attached to IC die 104 in a hybrid bonding process. In an example, IC dies 106, 108 have multiple layers 150 comprising active devices, e.g., transistors, metallization, and dielectric material. Multiple layers 150 may include active device layer 308, metallization layer 310, and dielectric layers 312. IC dies 106, 108 also have a layer 152, which may be silicon, at or near a back side 314 of the IC dies.

Referring to FIG. 2A, dielectric material 110 is provided between the top IC dies 106, 108 at manufacturing stage 206. In addition, the dielectric material 110 and top IC dies 106, 108 are thinned and upper surface 316 is planarized at manufacturing stage 206. **FIG. 3C** illustrates a simplified cross-sectional view of IC dies 104, 106, and 108 after completion of manufacturing stage 206.

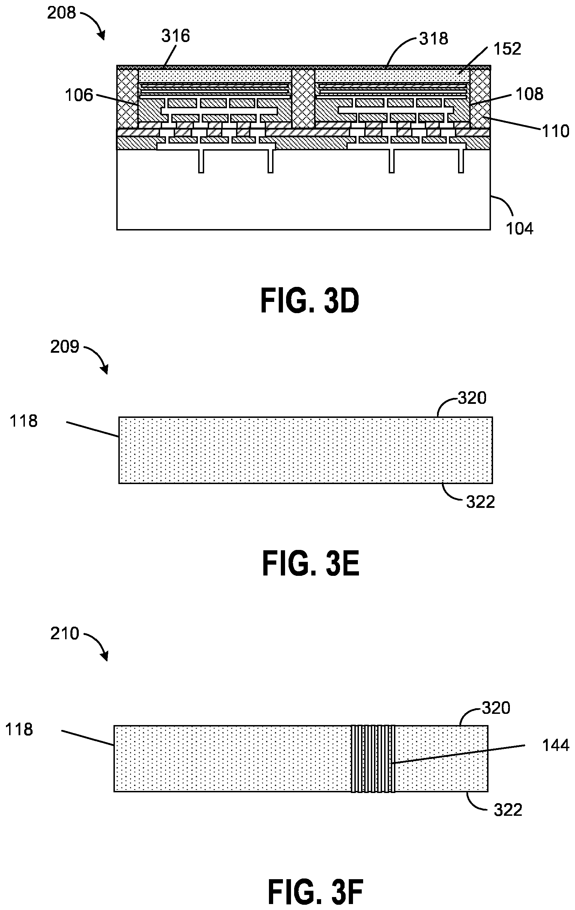

At manufacturing stage 208, a dielectric material 318 is deposited on upper surface 316 of the IC dies 106, 108 and dielectric material 110. The dielectric material 318 is an oxide of silicon in one example. **FIG. 3D** illustrates a simplified cross-sectional view of IC dies 104, 106, and 108 after completion of manufacturing stage 208.

Referring to FIG. 2A, structural silicon, e.g., structural silicon 118, is received at manufacturing stage 209. **FIG. 3E** illustrates a simplified cross-sectional view of structural silicon 118 at manufacturing stage 209. An array of features 144 are formed in the structural silicon at manufacturing stage 210. **FIG. 3F** illustrates a simplified cross-sectional view of structural silicon 118 after an array of features 144 have been formed at manufacturing stage 210. In some examples, the features 144 are elongated structures, e.g., pillars, that extend vertically between bottom surface 320 and top surface 322 of the structural silicon 118. (Structural silicon 118 is shown in an upside-down orientation in FIGS. 3E-3Fas compared with its orientation in the final IC package.) Features 144 are comprised of a material or materials with high thermal conductivity, e.g., copper. In the final IC package, bottom surface 320 is near bottom IC die 104 and hybrid bonding interface layer 142. In the final IC package, top surface 322 is near heat sink 120.

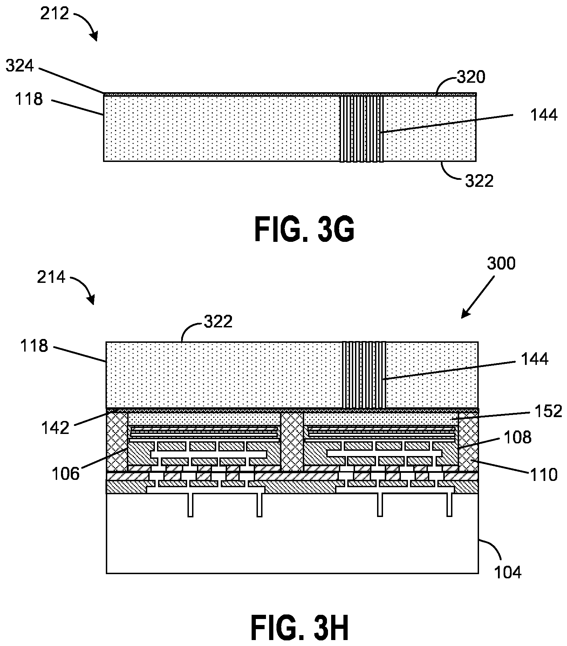

A dielectric material 324 is deposited on bottom surface 320 of structural silicon 118 at manufacturing stage 212. **FIG. 3G** illustrates a simplified cross-sectional view of structural silicon 118 after dielectric material 324 has been deposited on bottom surface 320.

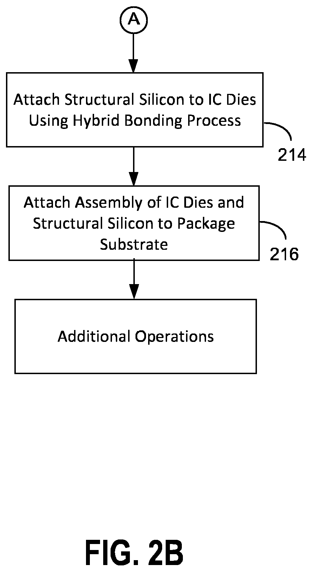

Referring to FIG. 2B, structural silicon 118 is attached to top IC dies 106, 108 in a hybrid bonding process at manufacturing stage 214. **FIG. 3H** illustrates a simplified cross-sectional view of IC dies 104, 106, and 108 after the structural silicon 118 has been attached to the top IC dies 106, 108. The dielectric material 318 on upper surface 316 of the top IC dies 106, 108 fuses with the dielectric material 324 on bottom surface 320 of structural silicon 118 to form hybrid bonding interface layer 142.

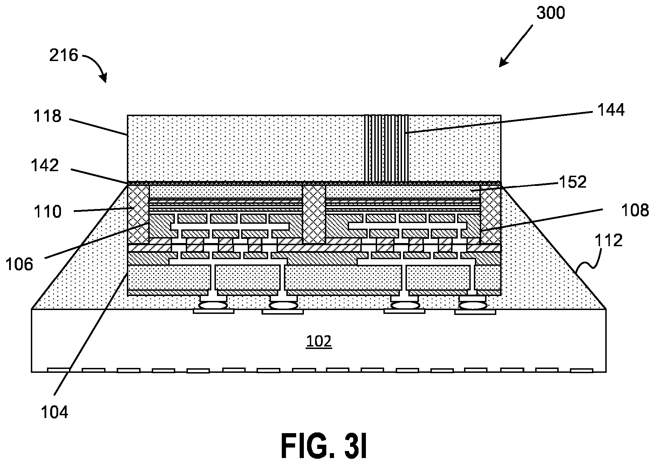

Referring to FIG. 2B, IC die 104 is thinned, and structural silicon 118 and IC dies 104, 106, and 108 are attached to a package substrate, e.g., package substrate 102, at manufacturing stage 216. In addition, IC dies 106, and 108 are encapsulated in mold material 112 at manufacturing stage 216. In subsequent stages of manufacturing, a heat sink 120 may be attached and singulation operations may be performed. The singulation operations create multiple IC packages from a wafer. **FIG. 3I** illustrates a simplified cross-sectional view of first example IC package 300 after the operations at manufacturing stage 216 have been performed.

Fabrication of the second example IC package 400 includes manufacturing stages that are substantially similar to the stages of manufacturing of the first example IC package 300. Referring to FIG. 2A, fabrication of the second example IC package 400 includes manufacturing stages 202, 204, 206, 208, and 212 depicted in FIGS. 3A-3E. However, fabrication of the second example IC package 400 does not include manufacturing stage 210 (forming an array of features in structural silicon), depicted in FIG. 3F. Instead, fabrication of the second example IC package 400 includes manufacturing stage 218, described below. Fabrication of the second example IC package 400 also includes stages 214 and 216.

At manufacturing stage 218, an array of features 402 are formed in the dielectric material 324 on surface 320 of structural silicon 118. In addition, at manufacturing stage 218, an array of features 404 are formed in the dielectric material 318 on upper surface 316 of the IC dies 106, 108 and dielectric material 110. Features 402 extend through dielectric material 324 and features 404 extend through dielectric material 318. Features 402, 404 comprise a material or materials with high thermal conductivity, such as copper. **FIG. 4A** illustrates a simplified cross-sectional view of structural silicon 118 after operations at manufacturing stage 218 have been performed. **FIG. 4B** illustrates a simplified cross-sectional view of IC dies 104, 106, and 108 after operations at manufacturing stage 218 have been performed.

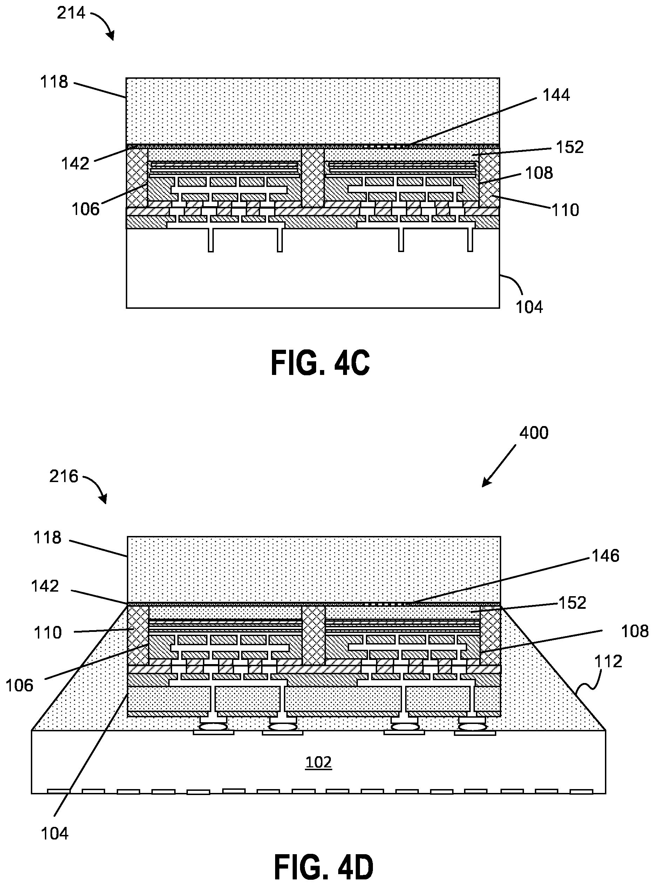

Fabrication of the second example IC package 400 includes manufacturing stage 214, which may be performed after manufacturing stage 218. At manufacturing stage 214, structural silicon 118 is attached to top IC dies 106, 108 in a hybrid bonding process. **FIG. 4C** illustrates a simplified cross-sectional view of IC dies 104, 106, and 108 after manufacturing stage 214 has been performed for the second example IC package 400. The dielectric material 318 fuses with the dielectric material 324, and features 402 bond with features 404 to form hybrid bonding interface layer 142.

Fabrication of the second example IC package 400 includes manufacturing stage 216. At manufacturing stage 216, structural silicon 118 and IC dies 104, 106, and 108 are attached to a package substrate, e.g., package substrate 102. In addition, IC dies 106, and 108 are encapsulated mold material 112 at manufacturing stage 216. In subsequent stages of manufacturing, a heat sink 120 may be attached and singulation operations may be performed. The singulation operations create multiple IC packages from a wafer. **FIG. 4D** illustrates a simplified cross-sectional view of the second example IC package 400 after the operations at manufacturing stage 216 have been performed.

Fabrication of the third example IC package 500 includes manufacturing stages that are substantially similar to the stages of manufacturing of the first example IC package 300 and second example IC package 400. Referring to FIG. 2A, fabrication of the third example IC package 500 includes manufacturing stages 202, 204, 206, 208, 209, 210 and 212 depicted in FIGS. 3A-3G. In addition, fabrication of the third example IC package 500 includes manufacturing stage 218, depicted in FIGS. 4A-4B. Fabrication of the third example IC package 500 includes manufacturing stages 214 and 216.

**FIGS. 5A and 5B** illustrate simplified cross-sectional views of third example IC package 500 after the operations at manufacturing stage 218 have been performed. FIG. 5A illustrates structural silicon member 118 after an array of features 144 of a material with high thermal conductivity have been formed within structural silicon 118 and after features 402 have been formed through dielectric material 324. FIG. 5B illustrates an array of features 404 are formed in the dielectric material 318 on the upper surface 316 of the IC dies 106, 108 and dielectric material 110.

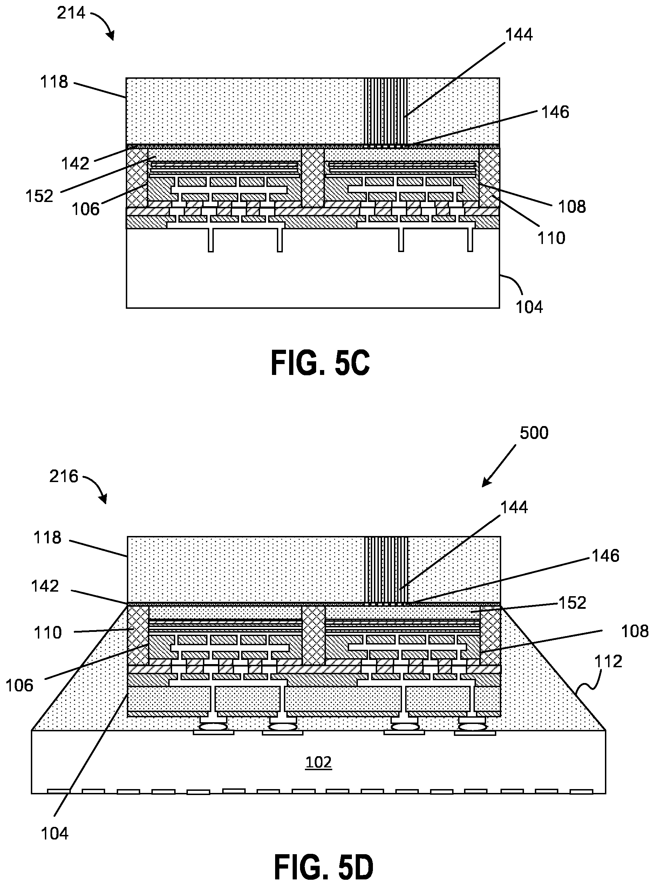

Fabrication of the third example IC package 500 includes manufacturing stage 214, which may be performed after manufacturing stage 218 where structural silicon 118 is attached to top IC dies 106, 108 in a hybrid bonding process. **FIG. 5C** illustrates a simplified cross-sectional view of IC dies 104, 106, and 108, and structural silicon member 118 after manufacturing stage 214 has been performed for the third example IC package 500. The dielectric material 318 fuses with the dielectric material 324, and features 402 bond with features 404 to form hybrid bonding interface layer 142. In an example, features 144 are vertically aligned with features 146.

Fabrication of the third example IC package 500 includes manufacturing stage 216 where the structural silicon member 118, and IC dies 104, 106, and 108, and structural silicon member 118 are attached to a package substrate. In addition, IC dies 106, and 108 are encapsulated mold material 112 at manufacturing stage 216. In subsequent stages of manufacturing, a heat sink 120 may be attached and singulation operations may be performed. The singulation operations create multiple IC packages from a wafer. **FIG. 5D** illustrates a simplified cross-sectional view of the third example IC package 500 after the operations at manufacturing stage 216 have been performed.

Fabrication of a fourth example IC package 600 may include all of the manufacturing stages required for third example IC package 500. Specifically, fabrication of a fourth example IC package 600 may include manufacturing stages: 202, 204, 206, 208, 209, 210, 212, 214, 216, and 218. Fourth example IC package 600 includes an array of heat conducting features within one of the top IC dies near a hot spot within the die. Fourth example IC package 600 combines an array of heat conducting features within an IC die with an array of features integrated into a structural silicon member and an array of features within the hybrid bonding interface 142.

Referring to FIG. 2A, an array of features is formed in a top IC die, e.g., IC die 106 or 108 at stage of manufacturing 220. In some examples, the features 148 are elongated structures, e.g., pillars, that extend vertically between a back side 314 of IC die 106 or 108 and a dielectric layer within the IC die. The array of features are passive in that they are not connected or coupled to any active devices, metallization, or electrical circuitry within the top IC die. The array of features may be located near a predominate source of heat, e.g., a hot spot, within the IC die. **FIG. 6A** illustrates a simplified cross-sectional view of IC die 108 after manufacturing stage 220.

At manufacturing stage 204, IC dies 106, 108 are attached to IC die 104 in a hybrid bonding process. **FIG. 6B** illustrates a simplified cross-sectional view of the IC dies 104, 106, and 108 after manufacturing stage 204. In the example illustrated in FIG. 6B, an array of features 148 is formed in IC die 108 at manufacturing stage 220 and manufacturing stage 204 is subsequent to manufacturing stage 220.

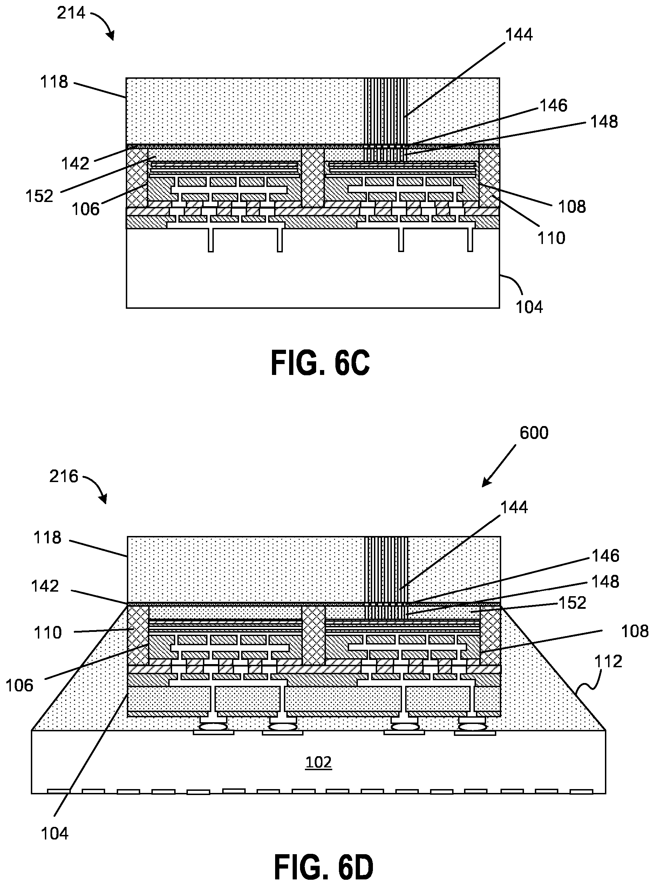

Fabrication of the fourth example IC package 600 includes manufacturing stage 214, which may be performed after manufacturing stage 218 where structural silicon 118 is attached to top IC dies 106, 108 in a hybrid bonding process. **FIG. 6C** illustrates a simplified cross-sectional view of IC dies 104, 106, and 108, and structural silicon member 118 after manufacturing stage 214 has been performed for the fourth example IC package 600. The dielectric material 318 fuses with the dielectric material 324, and features 402 bond with features 404 to form hybrid bonding interface layer 142. In an example, features 148 are vertically aligned with features 146.

Fabrication of the fourth example IC package 600 includes manufacturing stage 216 where the structural silicon member 118, and IC dies 104, 106, and 108, and structural silicon member 118 are attached to a package substrate. In addition, IC dies 106, and 108 are encapsulated mold material 112 at manufacturing stage 216. In subsequent stages of manufacturing, a heat sink 120 may be attached and singulation operations may be performed. The singulation operations create multiple IC packages from a wafer. **FIG. 6D** illustrates a simplified cross-sectional view of the fourth example IC package 600 after the operations at manufacturing stage 216 have been performed.

In some examples, the array of heat conducting features 148 may be provided within an IC die in an IC package that only includes the array of features 146 within the hybrid bonding interface 142, but omits the array of features 144 within structural silicon member 118. In other examples, the array of heat conducting features 148 may be provided within an IC die in an IC package that only includes the array of features 144 within structural silicon member 118, but omits the array of features 146 within the hybrid bonding interface 142. In further examples, the array of heat conducting features 148 may be provided within an IC die in an IC package that omits both the array of features 144 within structural silicon member 118 and the array of features 146 within the hybrid bonding interface 142.

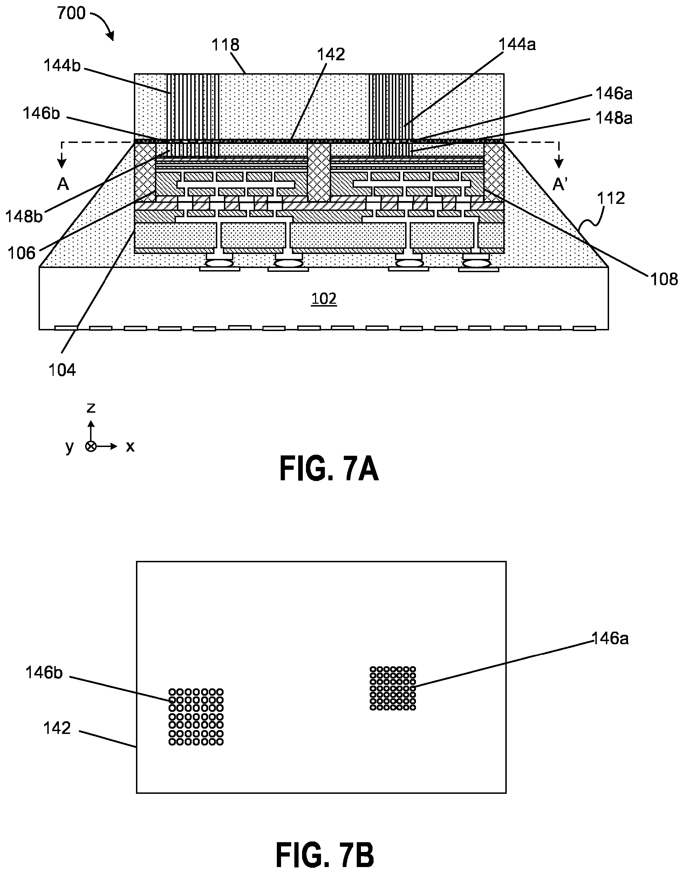

While the arrays of features 144, 146, and 148 illustrated in FIGS. 3I, 4D, 5D, and 6D of the first, second, third, and fourth example IC packages 300, 400, 500, and 600 are shown in particular locations in an x-y plane, it should be appreciated that these are example locations. The arrays of features 144, 146, and 148 may be provided at any suitable location or locations in the x-y plane. In some examples, a hot spot in a top die may be determined via simulation, testing, or experimentation, and any of the arrays of features 144, 146, and 148 may be provided in the determined location. **FIG. 7A** illustrates an example IC package 700 in accordance with some embodiments. IC package 700 includes arrays of heat conducting features 144a, 146a, and 148a over IC die 108, and arrays of heat conducting features 144b, 146b, and 148b over IC die 106. **FIG. 7B** illustrates a cross-section side view of the IC package 700 taken along the line A-A'. As can be seen in FIGS. 7A and 7B, the respective x-y locations of arrays of features 144a, 146a, and 148a with respect to IC die 108 are different than the respective x-y locations of arrays of features 144b, 146b, and 148b with respect to IC die 106. In addition, the respective sizes and spacing of arrays of features 144a, 146a, and 148a is different from arrays of features 144b, 146b, and 148b.

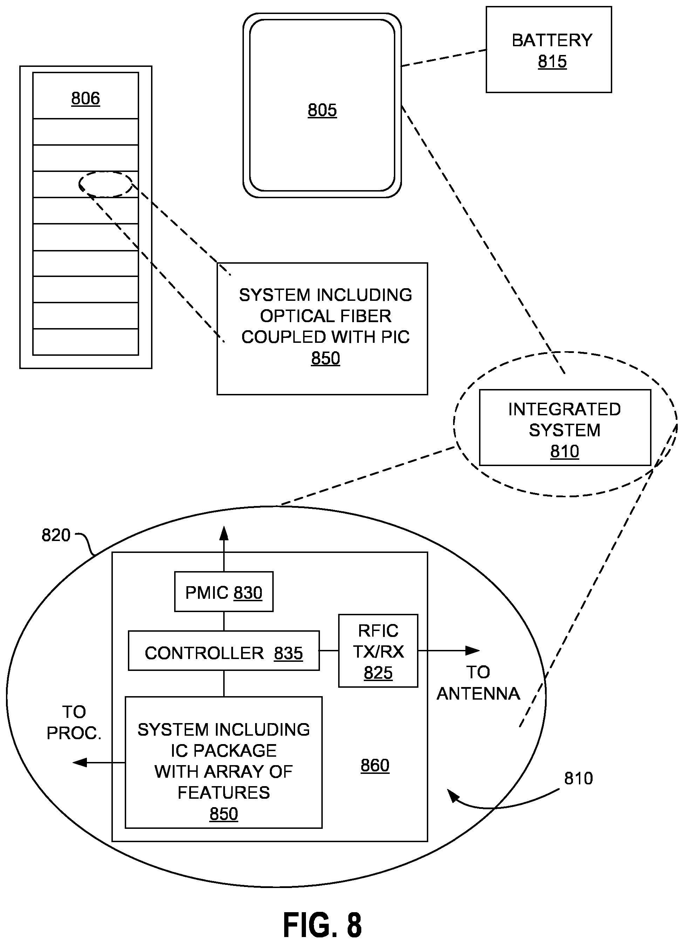

**FIG. 8** illustrates a mobile computing platform and a data server machine employing one or more apparatus comprising an IC package comprising an array of heat conducting features in a structural silicon member, a hybrid bonding interface layer, and/or a top IC die, for example as described elsewhere herein. For example, mobile computing platform 805 or server machine 806 may include an IC package comprising an array of heat conducting features in a structural silicon member, a hybrid bonding interface layer, and/or a top IC die as described elsewhere herein. Server machine 806 may be any commercial server, for example including any number of high-performance computing platforms disposed within a rack and networked together for electronic data processing. The mobile computing platform 805 may be any portable device configured for each of electronic data display, electronic data processing, wireless electronic data transmission, or the like. For example, the mobile computing platform 805 may be any of a tablet, a smart phone, laptop computer, etc., and may include a display screen (e.g., a capacitive, inductive, resistive, or optical touchscreen), a chip-level or package-level integrated system 810, and a battery 815.

Whether disposed within the integrated system 810 illustrated in the expanded view 820, or as a stand-alone package within the server machine 806, the integrated system or server machine includes an apparatus comprising an IC package comprising an array of heat conducting features in a structural silicon member, a hybrid bonding interface layer, and/or a top IC die, as described elsewhere herein. System 850 may be further coupled to a host substrate 860, along with, one or more of a power management integrated circuit (PMIC) 830, RF (wireless) integrated circuit (RFIC) 825 including a wideband RF (wireless) transmitter and/or receiver (TX/RX) (e.g., including a digital baseband and an analog front-end module further comprises a power amplifier on a transmit path and a low noise amplifier on a receive path), and a controller 835. PMIC 830 may perform battery power regulation, DC-to-DC conversion, etc., and so has an input coupled to battery 815 and with an output providing a current supply to other functional modules. As further illustrated, in the exemplary embodiment, RFIC 825 has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 4G, and beyond.

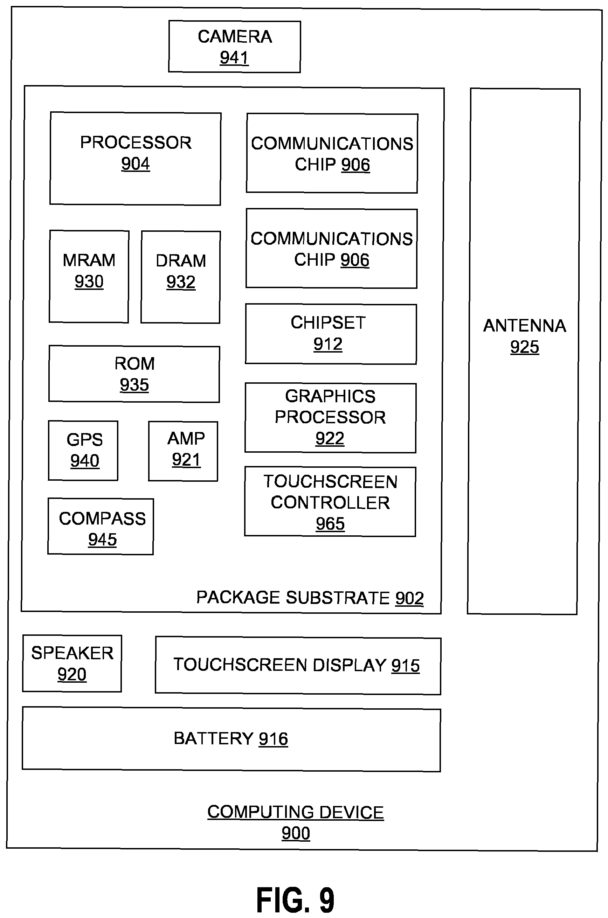

FIG. 9 is a functional block diagram of an electronic computing device 900, in accordance with an embodiment of the present invention. The computing device may be found inside mobile computing platform 805 or server machine 806, as described elsewhere herein. Device 900 further includes a package substrate 902 hosting a number of components, such as, but not limited to, a processor 904 (e.g., an applications processor). Processor 904 may be physically and/or electrically coupled to package substrate 902. In general, the term "processor" or "microprocessor" may refer to any device or portion of a device that processes electronic data from registers and/or memory to transform that electronic data into other electronic data that may be further stored in registers and/or memory. In some examples, one or more of the components of computing device 900 includes an optical fiber housing comprising alignment features on a surface of housing that interface with complimentary alignment features on a surface of a PIC die, as described elsewhere herein.

In various examples, one or more communication chips 906 may also be physically and/or electrically coupled to the package substrate 902. In further implementations, communication chips 906 may be part of processor 904. Depending on its applications, computing device 900 may include other components that may or may not be physically and electrically coupled to package substrate 902. These other components include, but are not limited to, volatile memory (e.g., DRAM 932), non-volatile memory (e.g., ROM 935), flash memory (e.g., NAND or NOR), magnetic memory (MRAM 930), a graphics processor 922, a digital signal processor, a crypto processor, a chipset 912, an antenna 925, touchscreen display 915, touchscreen controller 965, battery 916, audio codec, video codec, power amplifier 921, global positioning system (GPS) device 940, compass 945, accelerometer, gyroscope, speaker 920, camera 941, and mass storage device (such as hard disk drive, solid-state drive (SSD), compact disk (CD), digital versatile disk (DVD), and so forth), or the like..

Communication chips 906 may enable wireless communications for the transfer of data to and from the computing device 900. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. Communication chip 906 may implement any of a number of wireless standards or protocols. As discussed, computing device 900 may include a plurality of communication chips 906. For example, a first communication chip may be dedicated to shorter-range wireless communications, such as Wi-Fi and Bluetooth, and a second communication chip may be dedicated to longer-range wireless communications such as GPS, EDGE, GPRS, CDMA, WiMAX, LTE, Ev-DO, and others.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the invention is not limited to the embodiments so described, but can be practiced with modification and alteration without departing from the scope of the appended claims. For example, the above embodiments may include specific combinations of features as further provided below.

Example 1: An apparatus, comprising: a first integrated circuit (IC) die comprising a first surface; a second IC die laterally adjacent to the first IC die comprising a second surface; a structural member over an entirety of the first and second IC dies, the structural member comprising a first side facing the first and second surfaces, and one or more passive features; and a layer contacting the first side and both of the first and second surfaces, and comprising a dielectric material and a plurality of metal features extending between the first side and the first surface, wherein at least one of the metal features contacts one of the passive features.

Example 2: The apparatus of example 1 or example 2, wherein the metal features are first metal features, and the structural member further comprises a second side opposite the first side and a plurality of second metal features extending between the first and second sides, wherein the one or more passive features comprises the second metal features.

Example 3: The apparatus of example 1, wherein the structural member further comprises silicon at the first side and the one or more passive features comprises the silicon.

Example 4: The apparatus of any of examples 1 through 3, wherein the structural member comprises silicon with 2% or less impurities.

Example 5: The apparatus of any of examples 1 through 4, wherein the structural member further comprises a second side opposite the first side, further comprising a heat sink or cold plate proximate the second side.

Example 6: The apparatus of any of examples 1 through 5, wherein the first IC die comprises a third surface opposite the first surface, the structural member further comprises a second side opposite the first side, and a first distance between the first and second sides is greater than or equal to a second distance between the first and third surfaces.

Example 7: The apparatus of any of examples 1 through 6, wherein the metal features are first metal features, and the first IC die further comprises: a silicon layer at the first surface; and a plurality of second metal features extending from the first surface into the silicon layer in a direction substantially perpendicular to first surface.

Example 8: The apparatus of any of examples 1 through 7, wherein the first IC die comprises dielectric layer, a metallization layer, and an active device layer, and the plurality of second metal features extend between the first surface and the dielectric layer.

Example 9: The apparatus of example 8, wherein one of the first metal features contacts one of the second metal features.

Example 10: The apparatus of any of examples 1 through 8, further comprising: a third IC die under the first and second IC dies, wherein the first IC die and the second IC die are coupled with the third IC die; and a package substrate coupled with the third IC die and a circuit board.

Example 11: The apparatus of any of examples 1 through 8, or example 10, wherein the dielectric material is a first dielectric material comprising an oxide of silicon, further comprising a second dielectric material laterally adjacent to the first and second IC dies, wherein the second dielectric material is different from the first dielectric material.

Example 12: An apparatus, comprising: a first integrated circuit (IC) die comprising a first surface and a second surface opposite the first surface; a second IC die comprising a third surface and a fourth surface opposite the third surface; a third IC die coupled with the first and second IC dies and comprising a fifth surface facing the second and fourth surfaces; a structural member comprising a first side and a second side opposite the first side, wherein the structural member comprises a plurality of metal features extending between the first and second sides; and a layer comprising oxygen contacting the first side and both of the first and third surfaces.

Example 13: The apparatus of example 12, wherein the metal features are first metal features, and the layer further comprises a plurality of second metal features extending between the first side and the first surface.

Example 14: The apparatus of example 12 or 13, wherein the first IC die further comprises: a silicon layer at the first surface; and a plurality of third metal features extending into the silicon layer.

Example 15: The apparatus of example 14, wherein one of the first metal features is aligned with one of the second metal features, and one of the second metal features is aligned with one of the third metal features.

Example 16: The apparatus of any of examples 12 through 15, further comprising a heat sink or cold plate proximate the second side.

Example 17: A system, comprising: a first integrated circuit (IC) die comprising a first surface and an active device layer; a second IC die comprising a second surface; a third IC die comprising a metallization layer, wherein the first and second IC dies are stacked on and coupled with the IC third die; a package substrate coupled with the third IC die; a structural member comprising a first side over the first and second surfaces; and a layer between the first side and both of the first and second surfaces, wherein the layer comprises a dielectric material and a plurality of features comprising a thermally conductive material extending between a passive feature proximate the first side and one of the first and second surfaces.

Example 18: The system of example 17, wherein the structural member comprises a second side opposite the first side, the plurality of features are a plurality of first features, and the thermally conductive material is a first thermally conductive material, wherein the passive feature comprises second features comprising a second thermally conductive material extending between the first and second sides.

Example 19: The system of example 17 or example 18, wherein the dielectric material is a first dielectric material and the first IC die further comprises: a layer comprising a second dielectric material adjacent to the first surface; and a plurality of metal features extending from the first surface into the layer.

Example 20: The system of any of examples 17 through 19, wherein the structural member comprises a second side opposite the first side, further comprising a heat sink or cold plate proximate the second side, and a circuit board coupled with package substrate.

## Claims

1. An apparatus, comprising:
a first integrated circuit (IC) die comprising a first surface;
a second IC die laterally adjacent to the first IC die comprising a second surface;
a structural member over an entirety of the first and second IC dies, the structural member comprising a first side facing the first and second surfaces, and one or more passive features; and
an interface layer contacting the first side and both of the first and second surfaces, wherein the interface layer comprises a dielectric material and a plurality of metal features extending between the first side and the first surface.

2. The apparatus of claim 1, wherein the metal features are first metal features, and the structural member further comprises a second side opposite the first side and a plurality of second metal features extending between the first and second sides, wherein the one or more passive features comprises the second metal features.

3. The apparatus of claim 2, wherein one of the first metal features contacts one of the second metal features.

4. The apparatus of claim 1, wherein the structural member further comprises silicon at the first side and the one or more passive features comprises the silicon.

5. The apparatus of claim 1, wherein the metal features are first metal features, and the first IC die further comprises:
a first layer comprising silicon at the first surface; and
a plurality of second metal features extending from the first surface into the first layer in a direction substantially perpendicular to first surface.

6. The apparatus of claim 5, wherein the first IC die comprises a second layer, a metallization layer, and an active device layer, wherein the second layer comprises a dielectric material, and the plurality of second metal features extend between the first surface and the second layer.

7. The apparatus of claim 5 or claim 6, wherein one of the first metal features contacts one of the second metal features.

8. The apparatus of any one of claim 5 through claim 7, wherein the first layer comprises silicon with 2% or less impurities.

9. The apparatus of any one of claim 1 through claim 8, wherein the structural member comprises silicon with 2% or less impurities.

10. The apparatus of any one of claim 1 through claim 9, wherein the first IC die comprises a third surface opposite the first surface, the structural member further comprises a second side opposite the first side, and a first distance between the first and second sides is greater than or equal to a second distance between the first and third surfaces.

11. The apparatus of any one of claim 1 through claim 10, wherein the interface layer comprises oxygen.

12. The apparatus of any one of claim 1 through claim 11, wherein the interface layer comprises a thickness in a range of one to four microns.

13. The apparatus of any one of claim 1 through claim 12, further comprising:
a third IC die under the first and second IC dies, wherein the first IC die and the second IC die are coupled with the third IC die; and
a second dielectric material laterally adjacent to the first and second IC dies, wherein the second dielectric material is different from the first dielectric material.

14. The apparatus of claim 1, wherein the metal features are first metal features, and:
the structural member further comprises a second side opposite the first side and a plurality of second metal features extending between the first and second sides, wherein the one or more passive features comprises the second metal features, wherein one of the first metal features contacts one of the second metal features;
the first IC die further comprises:
a first layer comprising silicon at the first surface; and
a plurality of third metal features extending from the first surface into the first layer in a direction substantially perpendicular to first surface, wherein one of the first metal features contacts one of the third metal features; and
the apparatus further comprises a third IC die under the first and second IC dies, wherein the first IC die and the second IC die are coupled with the third IC die.

15. The apparatus of claim 13 or claim 14, further comprising:
a package substrate coupled with the third IC die;
a circuit board coupled with the package substrate; and
a heat sink or cold plate over the structural member.
